(19) Europäisches Patentamt European Patent Office Office européen des brevets

(11) **EP 2 765 704 A1**

(12) **EUROPEAN PATENT APPLICATION**

(43) Date of publication:
**13.08.2014  Bulletin 2014/33**

(21) Application number: **13305166.4**

(22) Date of filing: **12.02.2013**

(51) Int Cl.:
*H03F 1/32* (2006.01)          *H03G 11/00* (2006.01)
*H04L 27/26* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Alcatel Lucent**
**75007 Paris (FR)**

(72) Inventor: **Cabezas Lopez, Meritxell**
**70435 Stuttgart (DE)**

(74) Representative: **Hofmann, Dirk et al**
**Alcatel-Lucent Deutschland AG**
**Intellectual Property & Standards**
**Lorenzstrasse 10**
**70435 Stuttgart (DE)**

(54)    **Method for signal conditioning in a processing apparatus and processing apparatus thereof**

(57)    The embodiments of the invention relate to a method for signal conditioning in a processing apparatus (PA1). The method contains the steps of generating a first signal (fw) with a predefined spectral bandwidth (BW), amplifying spectral components of said first signal (fw) with a frequency outside said predefined spectral bandwidth (BW) for obtaining an amplified first signal (fw_PE_OUT), processing said amplified first signal (fw_PE_ OUT) for obtaining a second signal (fw_DAC_OUT), and attenuating spectral components of said second signal (fw_DAC_OUT) with a frequency outside said predefined spectral bandwidth (BW) for obtaining an attenuated second signal (fw_DE_OUT). The embodiments of the invention further relate to a processing apparatus (PA1), which executes the signal conditioning method.

FIG. 1

**Description**

**FIELD OF THE INVENTION**

Embodiments of the invention relate to signal conditioning and, more particularly but not exclusively, to signal conditioning of radio frequency signals in a radio transmitter.

**BACKGROUND**

An RF power amplifier (RF = radio frequency) is used in a radio transmitter for increasing a power of a radio frequency signal, which is going to be transmitted over a radio link from a transmit antenna to a receive antenna. Thereby, the RF power amplifier increases amplitudes of an output signal of the RF power amplifier with respect to amplitudes of an input signal of the RF power amplifier. For avoiding a distortion of the output signal such as an occurrence of additional frequency components outside a predefined bandwidth of the radio frequency, the RF power amplifier is usually driven within a linear operating range, which is between zero input power and a threshold input power. The linear operating range is usually extended by a DPD processing unit (DPD = digital pre-distortion). Within the linear operating range a gain of the amplitudes of the input signal is constant for any combination of the amplitudes of the input signal and the amplitudes of the output signal and any signal distortions of the output signal can be avoided. For input signals with an input power above the threshold input power some part of the RF amplifier becomes saturated and cannot produce any more output power; this is called clipping, and results in the signal distortions.

An operation within the linear operating range can be achieved by an active clipping, preferably a soft clipping, of the input signal to a predefined clipping threshold. A clipping unit for performing the active clipping is usually arranged in a digital transmit path of the radio transmitter followed by an analogue transmit path, which contains the RF power amplifier. Digital signals, which pass the digital transmit path are converted by a DAC (DAC = digital-to-analogue converter) into analogue signals, which pass the analogue transmit path. This means, that any processing unit, which is located in the digital transmit path or the analogue transmit path between the clipping unit and the RF power amplifier may add spectral components such as so-called signal spikes to a passing signal with amplitudes above the threshold input power. Depending on a size of the amplitude of such spectral components, the output signal of the RF power amplifier may be distorted or even amplification characteristics of the RF power amplifier may be altered in a permanent way and thereby, the RF power amplifier may be defective.

In addition, many RF power amplifiers are slew rate limited, which sometimes limits a full power bandwidth to frequencies well below the RF power amplifier's small-signal frequency response. Slew rate is a maximum rate of change of the output signal that the RF power amplifier is able to provide. The slew rate is usually quoted in volts per second (or microsecond). For keeping abrupt changes of the input signal of the RF power amplifier within the slew rate and for not damaging the RF power amplifier, usually the input signal has to pass a so-called digital slew rate limiter within the digital signal path. In an exemplary slew rate limiter, a slew rate is limited so as not to pass a signal varying more abruptly than a wobble signal included in a difference signal generated by a differential amplifier, and this limited slew rate is used to process the difference signal to be outputted. Such a digital slew rate limiter may eliminate signal spikes as part of an input signal of the digital slew rate limiter but is not able to prevent an occurrence of signal spikes at the input of the RF power amplifier, when such signal spikes are generated especially by the DAC, which is located between the digital signal path and the analogue signal path.

**SUMMARY**

Signal peaks of spectral components of the input signal of the power amplifier with a signal power above the linear operating range may generate signal distortions inside and/or outside a predefined frequency bandwidth for a radio transmission or even may damage the power amplifier. Thus, objects of the embodiments of the invention are operating the power amplifier within the linear operating range.

The object is achieved by a method for signal conditioning in a processing apparatus. The method contains the steps of generating a first signal with a predefined spectral bandwidth, amplifying spectral components of the first signal with a frequency outside the predefined spectral bandwidth for obtaining an amplified first signal, processing the amplified first signal for obtaining a second signal, and attenuating spectral components of the second signal with a frequency outside the predefined spectral bandwidth for obtaining an attenuated second signal. The object is further achieved by a processing apparatus for signal conditioning. The processing apparatus may be for example a transmitter, in particular a radio transmitter, and the signal may be for example a communication signal, in particular a radio communication signal. The transmitter may be for example a so-called direct modulation transmitter or a so-called heterodyne intermediate frequency transmitter.

Alternatively, the processing apparatus may be a switch, a router or a laser in optical communications, a repeater, a relay, or a radar system in wireless communications, a PCI (PCI = Peripheral Component Interconnect), a SATA (SATA = Serial AT Attachment) or a SAS (SAS = Serial Attached SCSI) in data transmission.

In further alternatives, the processing apparatus may be for example an audio amplifier, a digital camera, a printer, a digital display, a digital audio recorder, a spectrograph, a TWTA (TWTA = travelling wave tube amplifier), a motor control device or a machine vision device for industrial automation and image application or a medical device e.g. for generating ultrasound or any other processing apparatus, which requires bandwidth limited signals without spectral components outside the predefined spectral bandwidth having a signal power above a predefined power threshold.

The processing apparatus for signal conditioning contains means for generating a first signal with a predefined spectral bandwidth. In embodiments, the means for generating the first signal with the predefined spectral bandwidth may correspond to any signal generation unit, signal generator, function generator, RF or microwave signal generator, pitch generators, arbitrary waveform generator, digital pattern generator or frequency generator, which generates repeating or non-repeating electronic signals (in either the analog or digital domains). Hence, in embodiments, the means for generating the first signal with the predefined spectral bandwidth may contain a digital baseband board for a generating a basic signal with the predefined spectral bandwidth with an input for information such as data or voice to be applied for modulating the basic signal, and with an output for the first signal, which contains the modulated basic signal. In some embodiments the means for generating the first signal with the predefined spectral bandwidth can be implemented in terms of a computer program and a hardware component on which the computer program is executed, such as a DSP (DSP = Digital Signal Processor) or any other processor.

The processing apparatus further contains means for amplifying spectral components of the first signal with a frequency outside the predefined spectral bandwidth for obtaining an amplified first signal. In embodiments, the means for amplifying the spectral components of the first signal with the frequency outside the predefined spectral bandwidth may correspond to any amplification unit, amplifier, electric circuit, integrated circuit, which amplifies the spectral components with the frequency outside the predefined spectral bandwidth more than spectral components of the first signal with a frequency inside the predefined spectral bandwidth. Hence, in embodiments, the means for amplifying the spectral components of the first signal with the frequency outside the predefined spectral bandwidth may be a so-called pre-emphasis circuit, which contains an inverted low-pass filter such an inverted Bessel filter with an input for the first signal and with an output for the first signal containing amplified spectral components outside the predefined spectral bandwidth. In some embodiments the means for amplifying the spectral components of the first signal with the frequency outside the predefined spectral bandwidth can be implemented in terms of a computer program and a hardware component on which the computer program is executed, such as a DSP or any other processor.

The processing apparatus further contains at least one processing unit for processing the first signal and for obtaining a second signal. The at least one processing unit may be for example a DAC and the corresponding processing step may be a conversion of the first signal being a digital signal into the second signal being an analogue signal. Alternatively, the at least one processing unit may be an analog pre-distorter, since its spikes cannot be detected by a conventional method, e.g. based on a digital slew rate limiter. In a further alternative, the at least one processing unit may be a device using a digital signal conditioning algorithm such as IQEC (IQEC = IQ imbalance error correction), DPD or CFR (CFR = crest factor reduction). In further alternatives, the at least one processing unit may be a single integrated circuit, a single discrete state circuit or several integrated circuits or several discrete circuits connected in series such as commutators, transformers, diodes, power suppliers, etc, which may produce signal spikes in extreme or imbalanced operation conditions.

In some embodiments the at least one processing unit can be implemented in terms of a computer program and a hardware component on which the computer program is executed, such as a DSP or any other processor.

The processing apparatus further contains means for attenuating spectral components of the second signal with a frequency outside the predefined spectral bandwidth for obtaining an attenuated second signal. In embodiments, the means for attenuating the spectral components of the second signal with the frequency outside the predefined spectral bandwidth may correspond to any attenuation unit or attenuator, which attenuates the spectral components with the frequency outside the predefined spectral bandwidth more than the spectral components of the first signal with the frequency inside the predefined spectral bandwidth. Hence, in embodiments, the means for attenuating the spectral components of the first signal with the frequency outside the predefined spectral bandwidth may be a so-called de-emphasis circuit, which contains a low-pass filter such as a Butterworth filter with an input for the second signal and with an output for the second signal containing attenuated spectral components outside the predefined spectral bandwidth. In some embodiments the means for attenuating the spectral components of the second signal with the frequency outside the predefined spectral bandwidth can be implemented in terms of a computer program and a hardware component on which the computer program is executed, such as a DSP or any other processor.

The embodiments of the invention provide a first benefit of protecting a successive unit or device of the processing apparatus such as a power amplifier against signal spikes, which have been generated by one processing unit such as a DAC or by several processing units. Thereby, in can be prevented, that the power amplifier is operated in a saturation region of the power amplifier gain. As a result, malfunctions of the power amplifier and signal distortions of the output signal of the power amplifier can be avoided.

The embodiments of the invention provide a second benefit of increasing ruggedness of the processing apparatus, and especially of signal transmitters with respect to signal distortions, which has been caused by imperfect analogue signal processing components or by imperfect digital signal processing algorithms.

The embodiments of the invention provide a third benefit of increasing a reliable working of the processing apparatus especially with respect to tolerances in fabrication processes of analogue signal processing components or with respect to aging processes of the signal processing components.

In a preferred embodiment, coefficients of a transfer function of the Bessel filter and coefficients of a transfer function of the inverse Butterworth filter are both based on order 5. This provides the advantage of offering a compromise between performance and fabrication costs. The order 5 provides on the one hand a sufficient amplification and attenuation of spectral components outside the predefined spectral bandwidth. On the other hand, computing capacities such as processor resources and memory resources for the Bessel filter and a number of electronic components such as capacitors and inductors for the Butterworth filter can be kept low.

In a further preferred embodiment, a relative frequency difference for a same gain value or a same attenuation value of a spectral characteristic of the pre-emphasis circuit and of a spectral characteristic of the de-emphasis circuit may be within a predefined range, in particular from 0 percent to 2 percent for the predefined spectral bandwidth being equal to or larger than 20 MHz or from 0 percent to 4 percent for the predefined spectral bandwidth being smaller than 20 MHz. The further preferred embodiment offers by selecting appropriate spectral characteristics for the pre-emphasis circuit and the de-emphasis circuit the benefit of not requiring any post processing of the feedback signal for obtaining a convergence of an algorithm of the pre-distortion unit.

In further embodiments, the method further contains the steps of pre-distorting before the amplifying step the first signal based on a digital form of a feedback signal, up-converting the attenuated second signal, in particular I/Q samples of the attenuated second signal, with a predefined frequency for obtaining an up-converted second signal, amplifying the up-converted second signal for obtaining an amplified second signal, extracting the feedback signal from the amplified second signal, and adapting and removing a frequency offset between the feedback signal and the first signal.

The further embodiments provide the advantage of achieving a convergence of an algorithm of the pre-distortion unit, when the relative frequency difference for the same gain value or the same attenuation value of the spectral characteristic of the pre-emphasis circuit and of the inverse spectral characteristic of the de-emphasis circuit may be outside the predefined range, in particular above 2 percent for the predefined spectral bandwidth being equal to or larger than 20 MHz or above 4 percent for the predefined spectral frequency being smaller than 20 MHz.

According to a first one of the further embodiments, the method further contains the step of filtering the feedback signal by a low pass filter with a cut-off frequency adapted to half size of said predefined spectral bandwidth.

Therefore, the processing apparatus further contains means for filtering the feedback signal with the cut-off frequency adapted to the half size of said predefined spectral bandwidth. In embodiments, the means for filtering the feedback signal with the cut-off frequency adapted to the half size of said predefined spectral bandwidth may correspond to any electronic filter such as a low-pass filter, which passes low-frequency signals and attenuates (reduces the amplitude of) signals with frequencies higher than the cut-off frequency. Hence, in embodiments, the means for filtering the feedback signal with the cut-off frequency adapted to the half size of said predefined spectral bandwidth may contain low-pass filter with an input for the feedback signal and with an output for the filtered feedback signal. In some embodiments the means for filtering the feedback signal with the cut-off frequency adapted to the half size of said predefined spectral bandwidth can be implemented in terms of a computer program and a hardware component on which the computer program is executed, such as a DSP (DSP = Digital Signal Processor) or any other processor.

With respect to a second one of the further embodiments, the adapting and removing step contains a time delay compensation of the first signal and the digital form of the feedback signal.

In this case, the processing apparatus further contains means for compensating a time difference between the first signal and the feedback signal. In embodiments, the means for compensating the time difference between the first signal and the feedback signal may correspond to any time delay compensation unit or time delay compensator such as an electronic circuit or a mathematical algorithm, which eliminates a time delay between the first signal and the feedback signal. Hence in embodiments, the means for compensating the time difference between the first signal and the feedback signal may contain the electronic circuit or the mathematical algorithm with two inputs for the first signal and the feedback signal and two outputs for the first signal and the feedback signal with only one or both signals being time compensated. In some embodiments the means for compensating the time difference between the first signal and the feedback signal can be implemented in terms of a computer program and a hardware component on which the computer program is executed, such as a DSP or any other processor.

The processing apparatus further contains means for compensating a gain difference between the first signal and the feedback signal one or both being time compensated. In embodiments, the means for compensating the gain difference between the first signal and the feedback signal one or both being time compensated may correspond to any gain compensation unit or gain compensator such as an electronic circuit or a mathematical algorithm, which eliminates a gain difference between the first signal and the feedback signal. Hence in embodiments, the means for compensating the gain difference between the first signal and the feedback signal one or both being time compensated may contain the electronic circuit or the mathematical algorithm with two inputs for the first signal and the feedback signal with one or both being time compensated and two outputs for the first signal and the feedback signal with only one or both signals being gain compensated. In some embodiments the means for compensating the gain difference between the first signal and the feedback signal one or both being time compensated can be implemented in terms of a computer program and a hardware component on which the computer program is executed, such as a DSP or any other processor.

According to a third one of the further embodiments, the adapting and removing step contains a determination of the frequency offset and a down-conversion of the feedback signal by a sum frequency of the predefined frequency and the frequency offset.

Therefore, the processing apparatus further contains means for determining the frequency offset between the attenuated second signal and the feedback signal. In embodiments, the means for determining the frequency offset may correspond to any determination unit or calibration unit such as an LR estimator (LR = Likelihood Ratio), which calculates or outputs the frequency offset between the attenuated second signal and the feedback signal. Hence in embodiments, the means for determining the frequency offset may contain a determination unit with two inputs for the attenuated second signal and the feedback signal and with one output for the frequency offset. In some embodiments, parts of the means for determining the frequency offset may be implemented in terms of a computer program and a hardware component on which the computer program is executed, such as a DSP or any other processor.

The processing apparatus further contains means for demodulating or down-converting the feedback signal by the sum frequency. In embodiments, the means for demodulating the feedback signal by the sum frequency may correspond to any demodulator unit such as an I/Q demodulator, which performs a down-conversion from a high frequency of the feedback signal to an intermediate frequency of the feedback signal or to a feedback signal having spectral components around the zero frequency. Hence in embodiments, the means for demodulating the feedback signal may contain a demodulator unit with an input for the feedback signal, with an input for the sum frequency and with one output for a demodulated feedback signal. In some embodiments, parts of the means for demodulating the feedback signal by the sum frequency of the local oscillator frequency and the frequency offset can be implemented in terms of a computer program and a hardware component on which the computer program is executed, such as a DSP or any other processor.

Further advantageous features of the embodiments of the invention are defined and are described in the following detailed description.

## BRIEF DESCRIPTION OF THE FIGURES

The embodiments of the invention will become apparent in the following detailed description and will be illustrated by accompanying figures given by way of non-limiting illustrations.

Figure 1 shows schematically a block diagram of a transmitter apparatus according to a first embodiment of the invention.

Figure 2 shows a spectral filter characteristic of a pre-emphasis filter according to the first embodiment of the invention.

Figure 3 shows a spectral filter characteristic of de-emphasis filter according to the first embodiment of the invention.

Figure 4 shows schematically a block diagram of an attenuation unit according to the first embodiment of the invention.

Figure 5 shows schematically a block diagram of a method according to the first embodiment of the invention.

Figure 6 shows schematically a block diagram of a transmitter apparatus according to a second embodiment of the invention.

Figure 7 shows schematically a block diagram of a transmitter apparatus according to a third embodiment of the invention.

Figure 8 shows schematically a block diagram of a digital pre-distortion unit according to the third embodiment of the invention.

Figure 9 shows schematically a block diagram of a transmitter apparatus according to a fourth embodiment of the invention.

Figure 10 shows schematically a block diagram of a method according to the second, third and fourth embodiment of the invention.

## DESCRIPTION OF THE EMBODIMENTS

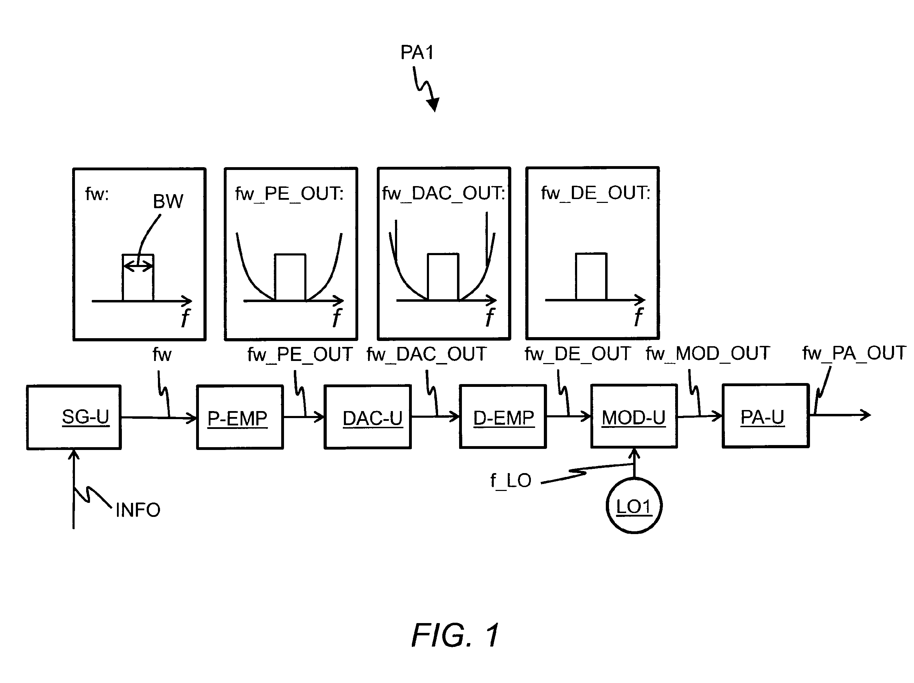

Figure 1 shows exemplarily a processing apparatus PA1 in a first embodiment as part of a transmitter apparatus for use in a radio access network node such as a base station, a mobile station or a relay network node. The term "base station" may be considered synonymous to and/or referred to as a base transceiver station, base station, Node B, enhanced Node B, access point etc. and may describe equipment that provides connectivity via a radio link between a radio communication system and one or more mobile stations. The term "mobile station" may be considered synonymous to, and may hereafter be occasionally referred to, as a mobile unit, mobile station, mobile user, access terminal, user equipment, subscriber, user, remote station etc. The mobile station may be for example cellular telephones, portable computers, pocket computers, hand-held computers, personal digital assistants, USB flash drives with a radio interface or car-mounted mobile devices. The term "relay network node" may be considered synonymous to, and may hereafter be occasionally referred to, as a relay node, relay, relay station, relay transmitter, repeater etc.

According to alternative embodiments, the processing apparatus PA1 may be part of a transmitter apparatus for use in a network node for optical transmissions via optical fibres or in a network node for electrical transmission via cables such as coaxial cables.

Alternatively, the processing apparatus PA1 may be a switch, a router or a laser in optical communications, a repeater, a relay, or a radar system in wireless communications, a PCI (PCI = Peripheral Component Interconnect), a SATA (SATA = Serial AT Attachment) or a SAS (SAS = Serial Attached SCSI) in data transmission.

In further alternatives, the processing apparatus PA1 may be for example an audio amplifier, a digital camera, a printer, a digital display, a digital audio recorder, a spectrograph, a TWTA, a motor control device or a machine vision device for industrial automation and image application or a medical device e.g. for generating ultrasound or any other processing apparatus, which requires bandwidth limited signals without spectral components outside a predefined spectral bandwidth or at least with spectral components outside the predefined spectral bandwidth having a signal power below a predefined power threshold.

The processing apparatus PA1 shown in Figure 1 is realized as a so-called direct modulation transmitter with a single modulation step for frequency up-conversion of communication signals such as radio communication signals around a frequency of 0 Hz to for example radio frequency signals with a frequency in the MHz or GHz range. The processing apparatus PA1 may be easily adapted by a person skilled in the art into a so-called heterodyne intermediate frequency transmitter as a further embodiment with a first modulation step preferably in the digital domain for up-converting communication signals around a frequency of 0 Hz to communication signals with an intermediate frequency such as 140 Hz and with a second modulation step preferably in the analogue domain for a further up-conversion from the intermediate frequency to for example radio frequency signals having a frequency in the MHz or GHz range.

The processing apparatus PA1 contains exemplarily a digital signal generation unit SG-U, an amplification unit P-EMP, a digital-to-analogue converter unit DAC-U, an attenuation unit D-EMP, a modulator unit MOD-U, a local oscillator LO1, and a power amplifier unit PA-U.

A so-called digital forward signal fw is generated with a predefined spectral bandwidth BW such as 1.4 MHz, 3 MHz, 5 MHz, 10 MHz or 20 MHz (see insertion figure for the digital forward signal fw in Figure 1) by the digital signal generation unit SG-U. The signal generation unit SG-U may correspond to any signal generation unit, signal generator, function generator, RF or microwave signal generator, pitch generator, arbitrary waveform generator, digital pattern generator or frequency generator known to a person skilled in the art, which generates repeating or non-repeating electronic signals (in either the analog or digital domains). The signal generation unit SG-U may be for example a digital baseband board with an input for information INFO such as data or voice, with one or several processing units for generating the digital forward signal fw according a radio communication standard such as GSM/GPRS (GSM = Global System for Mobile Communication, GPRS = General Packet Radio Service), UMTS (UMTS = Universal Mobile Telecommunication Systems), LTE (LTE = Long Term Evolution) or WiMAX (WiMAX = Worldwide Interoperability for Microwave Access) and with an output for the digital forward signal fw. The signal generation unit SG-U may be implemented in terms of a computer program and a hardware component on which the computer program is executed, such as a DSP, FPGA (FPGA = Field-programmable gate array) or any other processor.

The digital forward signal fw is provided to the amplification unit P-EMP, which amplifies spectral components of the digital forward signal fw with a frequency outside the predefined spectral bandwidth BW. The amplification unit P-EMP may correspond to any amplifier, electric circuit, integrated circuit, an inverted low-pass filter (e.g. in case of the processing apparatus PA1 being a direct modulation transmitter or a so-called), a pass-band filter (e.g. for an intermediate frequency in case of the processing apparatus PA1 being a heterodyne intermediate frequency transmitter), which amplifies the spectral components with the frequency outside the predefined spectral bandwidth BW considerably more (e.g. up to 70 dB) than spectral components with a frequency inside the predefined spectral bandwidth BW. Preferably, the amplification unit P-EMP may be a so-called pre-emphasis circuit, which contains a highpass filter such an inverse Bessel filter with an input for the digital forward signal fw and with an output for a digital forward signal fw_PE_OUT containing amplified spectral components outside the predefined spectral bandwidth BW (see insertion figure for the digital forward signal fw_PE_OUT in Figure 1). Thereby, spectral components of a noise floor of the digital forward signal fw outside the predefined spectral bandwidth BW are amplified.

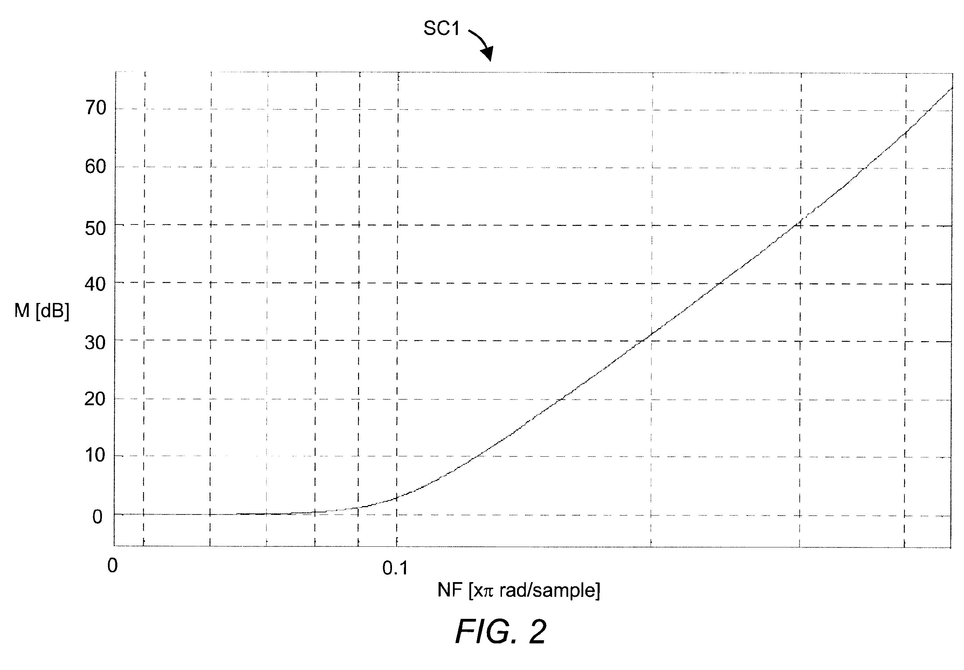

Figure 2 shows an exemplarily spectral filter characteristic SC1 of the amplification unit P-EMP with a gain magnitude in dB as a function of frequency normalized to a cut-off frequency $\omega_g$ of the high pass filter. The spectral filter characteristic SC1 is shown for an inverse Bessel filter with a preferred order 5 for coefficients $C_i$ of a transfer function of the inverse Bessel filter. In further alternatives, an inverse Bessel filter with an order 3 or an order 7 may be applied.

The transfer function of the frequency dependent gain for the inverted Bessel filter with order 5 can be expressed by following well-known equation:

$$A_{InversBessel} = \frac{1 + \sum_{i=1}^{5} c'_i P^i}{A_{Bessel,0}} \qquad (1)$$

with

$A_{Bessel,0}$ : DC voltage gain $P = \dfrac{p}{\omega_g} \Leftrightarrow j\Omega = j\,\dfrac{\omega}{\omega_g}$ : to the cut-off frequency $\omega_g$ normalized frequency

and with following recursion formula for the coefficients $C_i$ :

$i = 1 : c'_1 = 1$

$i = 2...n : \quad c'_i = \dfrac{2(n-i+1)}{i(2n-i+1)} \cdot c'_{i-1}$

An inverted Bessel filter in the digital domain is much easier to handle than for example an inverted Butterworth filter, because the inverted Bessel filter of order 5 can be realized with only a few coefficients in a compact way in terms of a computer program and a hardware component on which the computer program is executed, such as a DSP or any other processor in an FPGA or a DSP.

In an alternative embodiment, a digital pre-distortion unit may be applied between the digital signal generation unit SG-U and the amplification unit P-EMP for generating a pre-distorted digital forward signal.

The digital forward signal fw_PE_OUT is provided to the digital-to-analogue converter unit DAC-U. The digital-to-analogue converter unit DAC-U converts the digital forward signal fw_PE_OUT into an analogue forward signal fw_DAC_OUT. During the conversion process the digital-to-analogue converter unit DAC-U may generate outside the predefined spectral bandwidth BW signal spikes, which are superimposed to the analogue forward signal fw_DAC_OUT (see insertion figure for the analogue forward signal fw_DAC_OUT in Figure 1). The signal spikes may have a magnitude, which may be for example too large for a linear operation or a reliable operation of a succeeding power amplifier unit PA-U.

In alternative embodiments, the digital-to-analogue converter unit DAC-U may be replaced by a processing unit or by several processing units such as an analog pre-distorter, since its spikes cannot be detected by a conventional method, e.g. based on a digital slew rate limiter. In a further alternative, the at least one processing unit may be a device using a digital signal conditioning algorithm such as IQEC (IQEC = IQ imbalance error correction), DPD or CFR (CFR = crest factor reduction). In further alternatives, the at least one processing unit may be a single integrated circuit, a single discrete state circuit or several integrated circuits or several discrete circuits connected in series such as commutators, transformers, diodes, power suppliers, etc, which may produce signal spikes in extreme or imbalanced operation conditions, which may also generate signal spikes with a significant magnitude outside the predefined spectral bandwidth BW.

The analogue forward signal fw_DAC_OUT is provided to the attenuation unit D-EMP for attenuating spectral components of the analogue forward signal fw_DAC_OUT with a frequency outside the predefined spectral bandwidth BW. The attenuation unit D-EMP may correspond to any attenuation unit or attenuator, which attenuates the spectral components with the frequency outside the predefined spectral bandwidth BW significantly more (e.g. up to 70 dB) than the spectral components of the analogue forward signal fw_DAC_OUT with the frequency inside the predefined spectral bandwidth BW. The attenuation unit D-EMP may be for example a so-called de-emphasis circuit, which contains a low-pass filter such as a Butterworth filter with an input for the analogue forward signal fw_DAC_OUT and with an output for an analogue forward signal fw_DE_OUT containing attenuated spectral components outside the predefined spectral bandwidth BW. Thereby, the signal spikes, which have been superimposed to the analogue forward signal fw_DAC_OUT, and the spectral components of the noise floor of the digital forward signal fw outside the predefined spectral bandwidth BW are jointly attenuated to obtain the analogue forward signal fw_DE_OUT, which is an analogue copy of the digital forward signal fw.

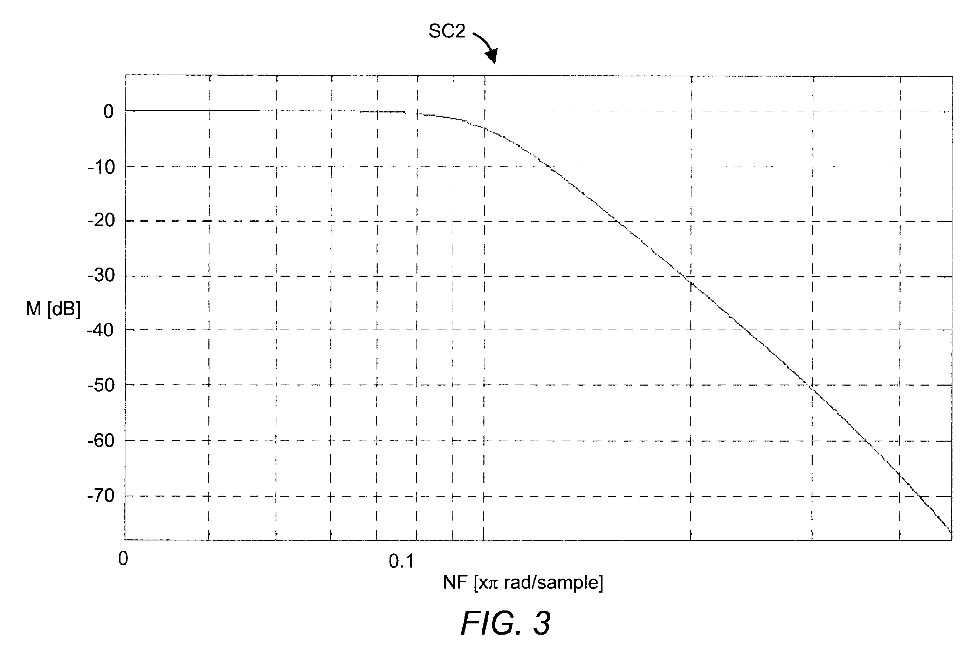

Figure 3 shows an exemplarily spectral filter characteristic SC2 of the attenuation unit D-EMP with a gain magnitude in dB as function of frequency normalized to the cut-off frequency $\omega_g$. The spectral filter characteristic SC2 is shown for a Butterworth filter with a preferred order 5 for coefficients $a_i$, $b_i$ of a transfer function of the Butterworth filter. In further alternatives, a Butterworth filter with an order 3 or an order 7 may be applied.

The transfer function of the frequency dependent gain for the Butterworth filter with order 5 can be expressed by following well-known equation:

$$A_{Butterworth} = \frac{A_{Butterworth,0}}{\prod_{i=1}^{3}(1 + a_i P + b_i P^2)} \qquad (2)$$

with

$A_{Butterworth,0}$ : DC voltage gain $\quad P = \dfrac{p}{\omega_g} \Leftrightarrow j\Omega = j\dfrac{\omega}{\omega_g}$ : to cut-off frequency $\omega_g$ normalized frequency

and with following recursion formula for the coefficients $a_i$, $b_i$ for an even order $n$ of the Butterworth filter:

$$i = 1 ... \frac{n}{2} : \quad a_i = 2\cos\frac{(2i-1)\pi}{2n} , \quad b_i = 1$$

and with following recursion formula for the coefficients $a_i$, $b_i$ for an odd order $n$ of the Butterworth filter:

$$i = 2 ... \frac{(n+1)}{2} : \quad a_1 = 1 , \quad b_1 = 0 , \quad a_i = 2\cos\frac{(i-1)\pi}{n} , \quad b_i = 1$$

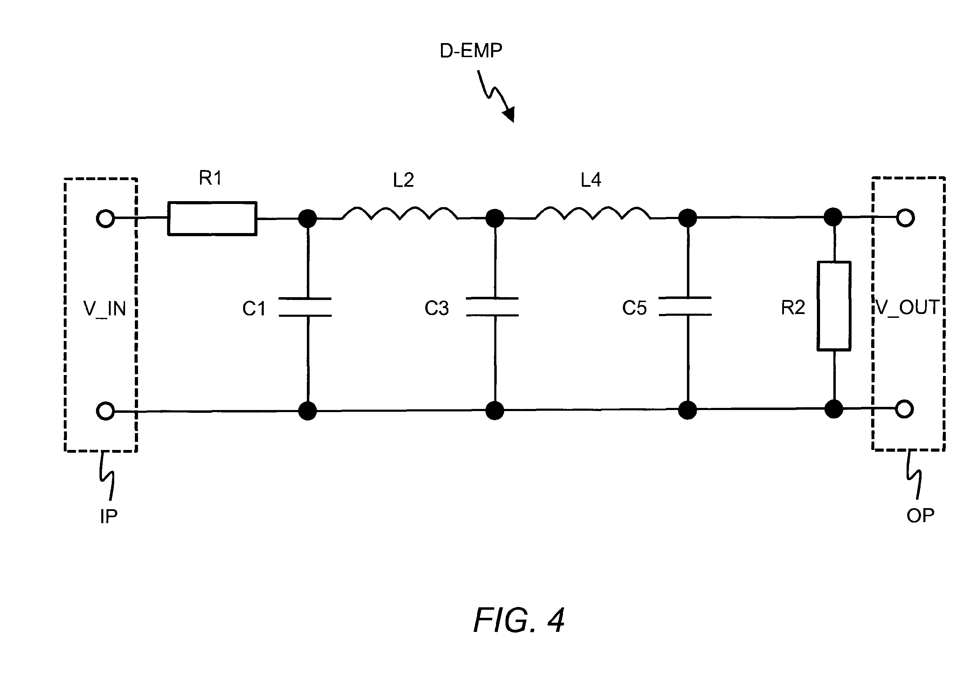

The attenuation unit D-EMP can be realized as an analogue Butterworth filter with the order 5 by an exemplarily electronic circuit as shown in Figure 4. The attenuation unit D-EMP exemplarily contains two input contacts of an input port IP for an input voltage V_IN, which corresponds to voltage values of the analogue forward signal fw_DAC_OUT, and further contains two output contacts of an output port OP for an output voltage V_OUT, which corresponds to voltage values of the analogue forward signal fw_DE_OUT. The exemplary attenuation unit D-EMP further contains two resistors R1, R2, two inductors L1, L2 and three capacitors C1, C2, C3.

A first resistor R1 of the two resistors R1, R2 and the two inductors L1, L2 are connected in series between one of the two input contacts and one of the two output contacts. The further one of the two input contacts and the further one of the two output contacts are short-circuited. The three capacitors C1, C2, C3 and a second resistor R2 of the two resistors R1, R2 are connected in parallel between the input port IP and the output port OP. Resistance values of the first resistor R1 and the second resistor R2 may be adapted to or chosen to avoid a reflection of radio frequency power at the input port IP and the output port OP and may be for example equal to 100 Ω. Capacity values for the three capacitors C1, and C5 may be for example equal to 100 pF and a capacity value of the capacitor C3 may be for example equal to 318 pF. Inductance values for the two inductors L2, L4 may be for example equal to 2500 nH.

Preferably, a relative frequency difference for a same gain value or a same attenuation value between the spectral characteristic SC1 of the amplification unit P-EMP and an inverted version of the spectral characteristic SC2 of the attenuation unit D-EMP may be identical or at least within a predefined range, in particular from 0 percent to 2 percent for the digital forward signal fw having a frequency bandwidth BW equal to or larger than 20 MHz or from 0 percent to 4 percent for the digital forward signal fw having a frequency bandwidth smaller than 20 MHz. This may be realized for example in a following way, if the amplification unit P-EMP is a digital device and if the attenuation unit D-EMP is an analogue device: At first, the amplification unit P-EMP will be produced according to a predefined design of the spectral characteristic SC2 and a real spectral characteristic SC2 of the attenuation unit D-EMP may be analyzed and measured.

A deviation between the predefined design of the spectral characteristic SC2 and the real spectral characteristic SC2 may be determined and used to determine a correction term for the transfer function shown in equation (1) so that the relative frequency difference is within the predefined range. Such a procedure may be applied for a limited number of high quality processing apparatuses.

The analogue forward signal fw_DE_OUT is provided to the modulator unit MOD-U. A frequency f_LO of the local oscillator LO1 is applied to the modulator unit MOD-U for an up-conversion of the analogue forward signal fw_DE_OUT to an analogue forward signal fw_MOD_OUT with a frequency in a frequency range of for example MHz or GHz. The analogue forward signal fw_MOD_OUT is provided to the power amplifier unit PA-U, which amplifies the analogue forward signal fw_MOD_OUT and emits an analogue forward signal fw_PA_OUT, which may be applied for example as a radio frequency signal to an antenna system for a wireless transmission.

For the alternative embodiment with the digital pre-distortion unit as mentioned above, a directional coupler may be applied between the power amplifier unit PA-U and the antenna system for extracting a small part of the analogue forward signal fw_PA_OUT as a feedback signal and for coupling the feedback signal into a feedback path for the digital pre-distortion unit.

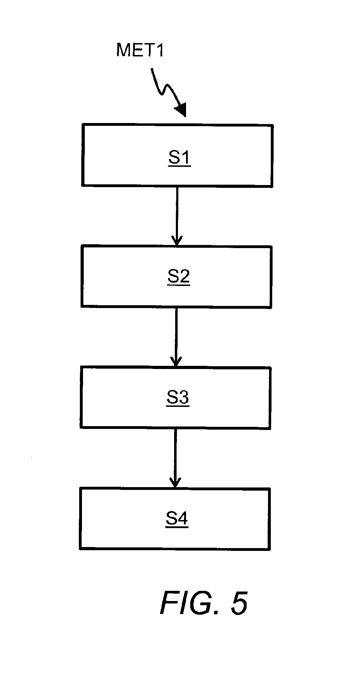

Referring to Figure 5 a flow diagram of a method MET1 containing four steps S1 to S4 in accordance to the first embodiment of the invention is shown. The number of the steps for performing the method MET1 is not critical, and as can be understood by those skilled in the art, that the number of the steps and the sequence of the steps, may vary without departing from the scope of the embodiments of the invention as defined in the appended claims. The various steps of the method MET1 are executed by corresponding processing units of the first processing apparatus PA1.

In a first step S1, a first signal such as the digital forward signal fw is generated with the predefined spectral bandwidth BW.

In a next step S2, spectral components of the first signal having a frequency outside the predefined spectral bandwidth BW are amplified. Thereby, the first signal is transformed into a signal such as the digital forward signal fw_PE_OUT.

In a further step S3, the first signal is converted into a second signal such as the analogue forward signal fw_DAC_OUT by one processing unit such as the digital-to-analogue converter unit DAC-U or by two or more processing units connected in series such as described.

In a next step S4, spectral components of the second signal with a frequency outside the predefined spectral bandwidth BW are attenuated. Thereby, the second signal is transformed into a signal such as the analogue forward signal fw_DE_OUT.

The method MET1 may be applied by any processing apparatus, which requires an elimination or suppression of signal spikes outside the predefined spectral bandwidth BW, when such signal spikes are generated by an intermediate processing unit or by several intermediate processing units of the processing apparatus with a level, amplitude or magnitude, which does not fulfil a predefined or required signal quality.

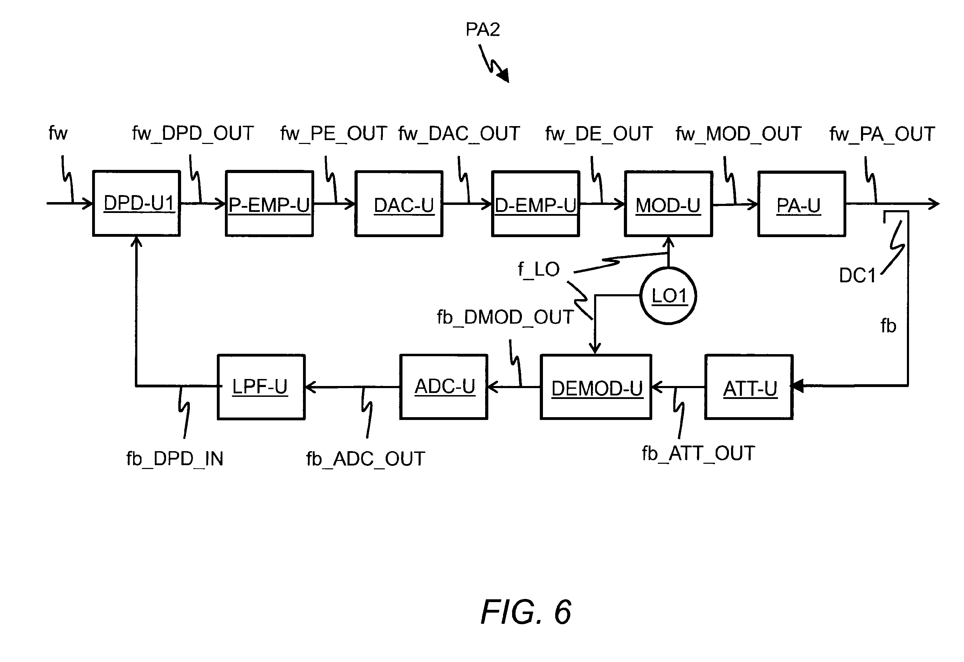

Figure 6 shows exemplarily a processing apparatus PA2 in a second embodiment as part of a transmitter apparatus. The elements in Figure 6 that correspond to elements of Figure 1 have been designated by same reference numerals. Only those technical aspects of the second embodiment will be described in the following, which are different to the first embodiment.

The processing apparatus PS2 further contains a feedback signal path with a digital pre-distortion unit DPD-U1, a directional coupler DC1, an attenuation unit ATT-U, a demodulator unit DEMOD-U, an analogue-to-digital converter unit ADC-U, and a low pass filter unit LPF-U.

The digital forward signal fw is provided to the digital pre-distortion unit DPD-U1 for generating a pre-distorted digital forward signal fw_DPD_OUT. The digital pre-distortion unit DPD-U1 may be based on any pre-distortion algorithm known to a person skilled in the art such as a so-called feed-forward scheme, a polynomial method, a method according to the so-called Wiener-Hammerstein model or algorithms based on so-called successive substitution, LMS (LMS = Least Mean Square), RLS (RLS = Recursive Least Square) or so-called secant method, that uses a succession of roots of secant lines to better approximate a root of a function $f$. The pre-distorted digital forward signal fw_DPD_OUT is provided as an input signal to the amplification unit P-EMP.

The analogue forward signal fw_PA_OUT as an output signal of the power amplifier unit PA-U passes the directional coupler DC1, which extracts a small part (e.g. 20 dB to 30 dB) of the analogue forward signal fw_PA_OUT as an analogue feedback signal fb and couples the analogue feedback signal fb into the feedback signal path for the digital pre-distortion unit DPD-U1. A remaining part of the analogue forward signal fw_PA_OUT may be applied for example as a radio frequency signal to an antenna system for a wireless transmission.

The analogue feedback signal fw is provided as an input signal to the attenuation unit ATT-U, which attenuates the analogue feedback signal fw to a power level, which can be processed by the successive analogue-to-digital converter unit ADC-U. Thereby, the attenuation unit ATT-U outputs or passes an analogue feedback signal fb_ATT_OUT, which is provided as an input signal to the demodulator unit DEMOD-U. The frequency f_LO of the local oscillator LO1 (as shown in Figure 6) or alternatively of a further local oscillator is applied to the demodulator unit DEMOD-U for a down-conversion of the analogue feedback signal fw_ATT_OUT with the frequency in the frequency range of for example MHz or GHz to an analogue feedback signal fb_DMOD_OUT with a frequency around 0 Hz. The analogue feedback signal fb_DMOD_OUT is provided to the analogue-to-digital converter unit ADC-U, which converts the analogue feedback signal fb_DMOD_OUT into a digital feedback signal fb_DPD_IN.

The digital feedback signal fb_DPD_IN is provided to the low pass filter unit LPF-U for filtering the digital feedback signal fb_DPD_IN. Preferably a cut-off frequency of the low pass filter unit LPF-U may be adapted or identical to a half size of the predefined spectral bandwidth BW. The low pass filter unit LPF-U may correspond to any electronic filter such as a low-pass filter, which passes low-frequency signals and attenuates (reduces the amplitude of) signals with frequencies higher than the cut-off frequency. The low pass filter unit LPF-U may contain an input for the digital feedback signal fb_DPD_IN and an output for a digital feedback signal fb_DPD_IN to be applied as a reference signal to the pre-distortion unit DPD-U1. The low pass filter unit LPF-U may be implemented in terms of a computer program and a hardware component on which the computer program is executed, such as a DSP, FPGA or any other processor.

The low pass filter unit LPF-U may be applied, if the relative frequency difference for a same gain value or a same attenuation value between the spectral characteristic SC1 of the amplification unit P-EMP and an inverted version of the spectral characteristic SC2 of the attenuation unit D-EMP is above a threshold, in particular above 2 percent for the digital forward signal fw having a frequency bandwidth BW equal to or larger than 20 MHz or above 4 percent for the digital forward signal fw having a frequency bandwidth smaller than 20 MHz.

The low pass filter unit LPF-U offers following advantage: The analogue forward signal fw_PA_OUT and the analogue feedback signal fb should follow a linear equation:

$$y = a_1 \cdot x \qquad (3)$$

with $a_1$ being a linear amplification factor of the power amplifier unit PA-U. Unfortunately, the power amplifier unit PA-U is a non-linear system, which generates inter-modulation products. Therefore, the analogue forward signal fw_PA_OUT and the analogue feedback signal fb follow according to a complex baseband model for power amplification a non-linear equation:

$$y = x \cdot \Gamma_{PA}(|x|) = x \cdot G(|x|) \cdot e^{i\Phi(|x|)} = \sum_{i=0}^{\infty} a_{2i+1} \cdot x|x|^{2i} \qquad (4)$$

with

$y$, $x$: Complex envelope of RF input and output signal,
$\Gamma_{PA}(|x|)$: Complex gain depending on the magnitude of the input signal,
$G(|x|)$: Magnitude of the gain,
$\Phi(|x|)$: phase shift,
$a_{2i+1}$: complex coefficients, $a_{2i+1}$ for $i > 0$ are non-linear amplification factors.

The digital pre-distortion unit DPD-U is usually applied for eliminating all the inter-modulation products of the analogue forward signal fw_PA_OUT. Unfortunately, if too large additional signal distortions (e.g. by increased non-linear amplification factors $a_{2i+1}$ for $i > 0$) are generated by a considerable frequency and/or gain mismatch between the spectral characteristic SC1 of the amplification unit P-EMP-U and inverted version of the spectral characteristic SC2 of the attenuation unit D-EMP-U, the digital pre-distortion unit DPD-U is not able work in a stable operating point and therefore is not able to eliminate all the inter-modulation products. By applying the low pass filter unit LPF-U, higher order inter-modulation products can be already attenuated and suppressed. Thereby, the digital pre-distortion unit DPD-U is able to eliminate the remaining inter-modulation products even if the additional signal distortions, which have been generated by the mismatch between the spectral characteristic SC1 of the amplification unit P-EMP-U and the inverted version of the spectral characteristic SC2 of the attenuation unit D-EMP-U, are present.

The low pass filter unit LPF-U being a digital filter may be implemented in an adaptive way (e.g. by an equalizer), to compensate for further signal distortions e.g. regarding a phase of spectral components of the digital feedback signal fb_DPD_IN.

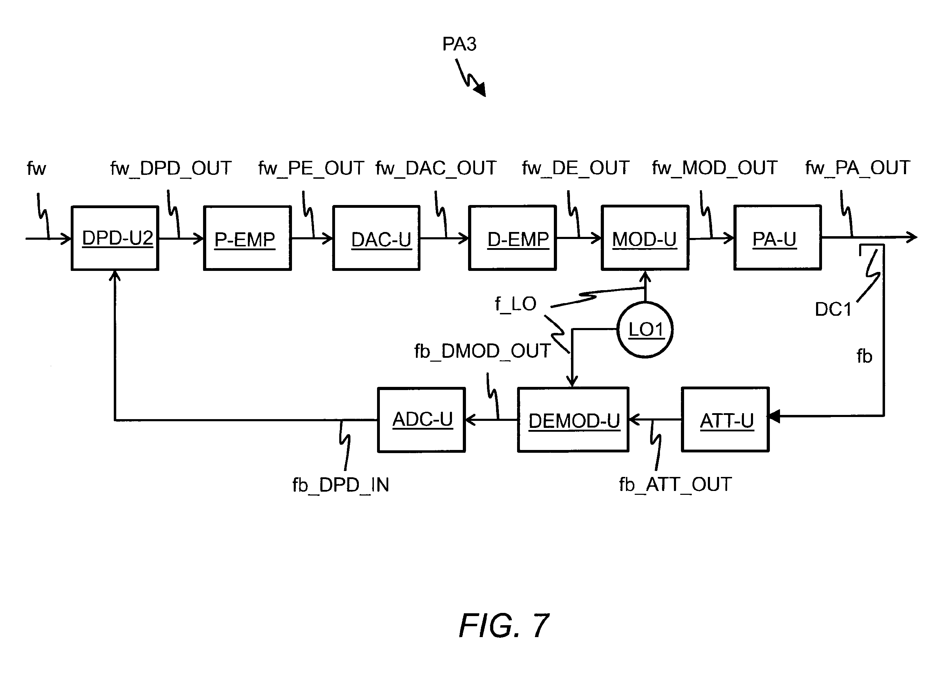

Figure 7 shows exemplarily a processing apparatus PA3 in a third embodiment as part of a transmitter apparatus. The elements in Figure 7 that correspond to elements of Figure 6 have been designated by same reference numerals. Only those technical aspects of the third embodiment will be described in the following, which are different to the second embodiment.

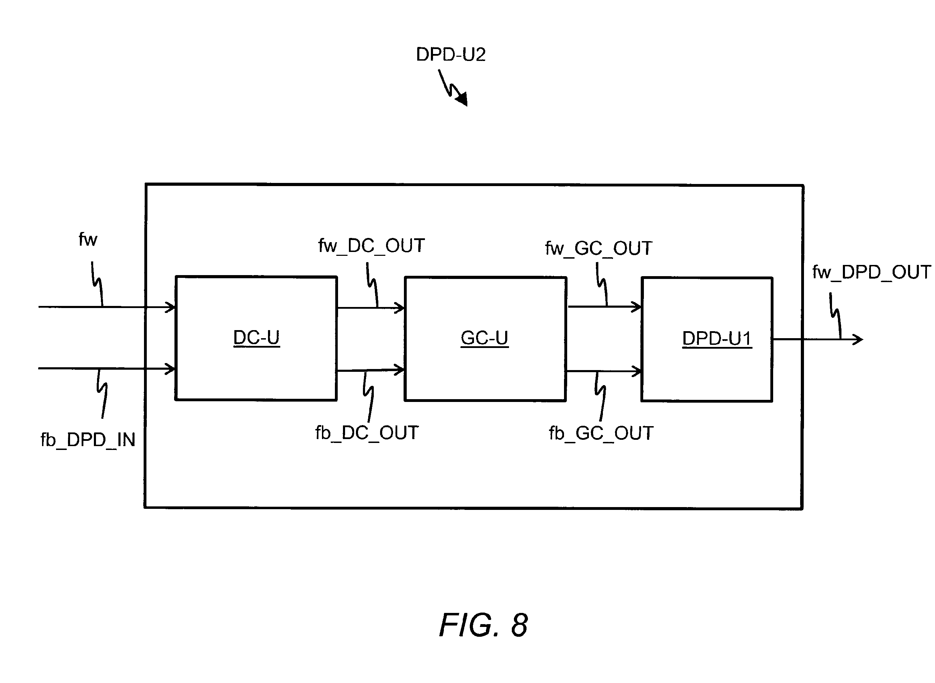

The digital pre-distortion unit DPD-U 1 is replaced by a digital pre-distortion unit DPD-U2, which is shown in Figure 8 in more detail. The low pass filter unit LPF-U is not applied for the shown embodiment but may be applied in an alternative embodiment, if the relative frequency mismatch between the spectral characteristic SC1 of the amplification unit P-EMP-U and the inverted version of the spectral characteristic SC2 of the attenuation unit D-EMP-U is too large as described above regarding Figure 6.

The digital pre-distortion unit DPD-U2 such as a DSP or FPGA contains for example a delay compensation unit DC-U, a gain compensation unit GC-U and the digital pre-distortion unit DPD-U1. In an alternative embodiment, a first DSP or FPGA contains the delay compensation unit DC-U and the gain compensation unit GC-U and a second DSP or FPGA contains the digital pre-distortion unit DPD-U1 . The alternative embodiment may be applied, if computing resources, which are required for extending a time window to cover a time delay between the digital forward signal fw and the digital feedback signal fb_DPD_IN, cannot be offered and conducted by a single DSP or FPGA.

The digital forward signal fw and the digital feedback signal fb_DPD_IN are provided as input signals to the delay compensation unit DC-U and can be written in the time domain for example by following equations:

$$fw(t) = \sum_{k=0}^{N} fw_{samples}(t-k) \tag{5}$$

$$fb\_DPD\_IN(t) = \sum_{k=0}^{M} fb\_DPD\_IN_{samples}(t-k) \tag{6}$$

This means that the digital forward signal fw is represented by a number of $N$ samples and the digital feedback signal fb_DPD_IN is represented by a number of $M$ samples and usually the number of $N$ samples is larger than the number of $M$ samples, because a smaller memory is usually applied for the samples of the digital feedback signal fb_DPD_IN than for the samples of the digital forward signal fw.

The delay compensation unit DC-U may determine a cross correlation between the digital forward signal fw of equation (5) and the digital feedback signal fb_DPD_IN of equation (6) for example according to following equation:

$$R_{fw-fb\_DPD\_IN}(\tau) = E\{fw(t) \cdot fb\_DPD\_in(t+\tau)\} = \alpha \cdot R_{fw-fw}(\tau - D) \tag{7}$$

with

$E$ : expectation operator,

$\alpha$ : constant factor,

$D$ : time delay or time difference between the digital feedback signal fb_DPD_IN and the digital forward signal fw.

The cross-correlation function $R_{fw-fb\_DPD\_IN}(\tau)$ achieves a maximum for $\tau = D$, which can be determined by calculating expectations values of the cross-correlation function $R_{fw-fb\_DP\_IN}(\tau)$ for a predefined number of samples within a pre-selected time window for example according to following equations:

$$R_{fw-fb\_DPD\_IN}(\tau) = \sum_{l=1}^{L} R_{fw-fb\_DPD\_IN}(\tau + l \cdot W) \tag{8}$$

$$L = \left[ \frac{\min(M,N)}{W} \right] \tag{9}$$

with $W$ being a window size and $[\cdot]$ the floor function.

If $D \geq 0$, samples 0 to D of the digital forward signal fw may be discarded and the digital forward signal fw and the digital feedback signal fb_DPD_IN may be written by following equations:

$$fw_{DC\_OUT}(t) = \sum_{k=1+D}^{P} fw_{samples}(t-k) \qquad (10)$$

$$fb_{DC\_OUT}(t) = \sum_{k=0}^{P} fb\_DPD\_IN_{samples}(t-k) \qquad (11)$$

with $P=\min(M,N-D-1)$.

If $D < 0$, samples 0 to $|D|$ (means absolute value of $D$) of the digital feedback signal fb_DPD_IN may be discarded and the digital forward signal fw and the digital feedback signal fb_DPD_IN may be written by following equations:

$$fw_{DC\_OUT}(t) = \sum_{k=0}^{P} fw_{samples}(t-k) \qquad (12)$$

$$fb_{DC\_OUT}(t) = \sum_{k=1+|D|}^{P} fb\_DPD\_IN_{samples}(t-k) \qquad (13)$$

with $P=\min(M-D-1,N)$.

The time compensated digital forward signal fw_DC_OUT and the time compensated digital feedback signal fb_DC_OUT are provided as input signals to the gain compensation unit GC-U.

The gain compensation unit GC-U may determine a complex gain value $k$ using least squares for example according to following equation:

$$K = \frac{fw_{DC\_OUT}^{*} \cdot fb_{DC\_OUT}}{fw_{DC\_OUT}^{*} \cdot fw_{DC\_OUT}} \qquad (14)$$

with $fw_{DC\_OUT}^{*}$ being a conjugate transpose of $fw_{DC\_OUT}$.

The gain compensation unit GC-U may further adapt or modify a gain of the time compensated digital forward signal fw_DC_OUT and the time compensated digital feedback signal fb_DC_OUT for example according to following equations:

$$fb_{CC\_OUT}(t) = \frac{fb_{DC\_OUT}(t)}{K} \qquad (15)$$

$$fw_{GC\_OUT}(t) = fw_{DC\_OUT}(t) \qquad (16)$$

The time compensated digital forward signal fw_GC_OUT and the gain and time compensated digital feedback signal fb_GC_OUT are provided as input signals to the digital pre-distortion unit DPD-U1.

The digital pre-distortion unit DPD-U2 allows compensating a frequency shift between the digital forward signal fw and the digital feedback signal fb_DPD_IN and generates the pre-distorted digital forward signal fw_DPD_OUT. Thereby, the pre-distorted digital forward signal fw_DPD_OUT once processed by the components and devices P-EMP, DAC-U, D-EMP is able to compensate frequency shifts, which would be otherwise present in the analogue output signals fw_DE_OUT, fw_MOD_OUT and fw_PA_OUT due to a non-perfect match between the spectral characteristic SP1 and an inverted version of the spectral characteristic SP2.

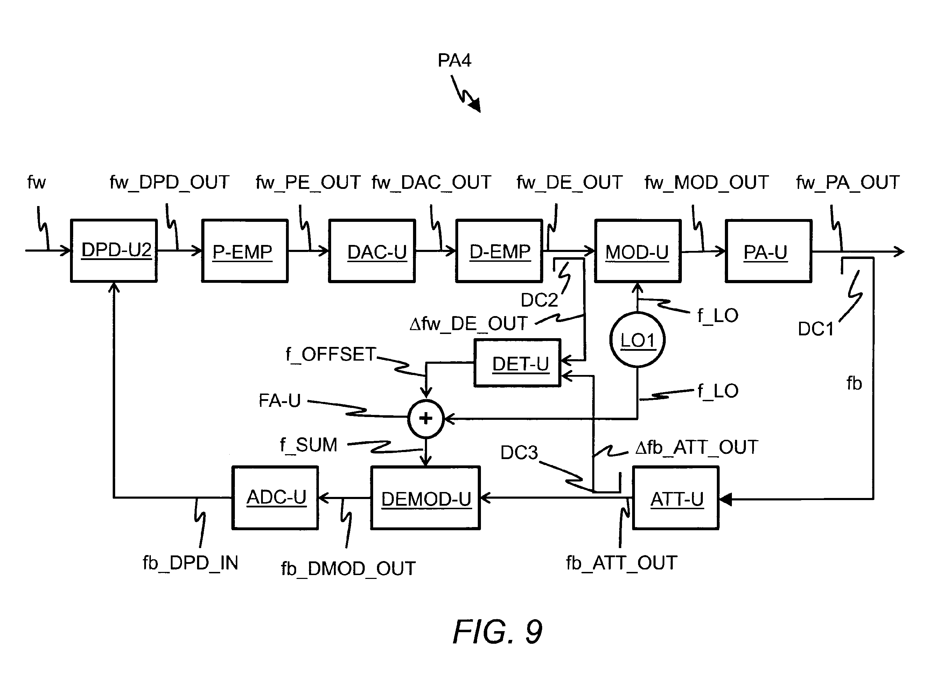

Figure 9 shows exemplarily a processing apparatus PA4 in a fourth embodiment as part of a transmitter apparatus. The elements in Figure 9 that correspond to elements of Figure 6 have been designated by same reference numerals. Only those technical aspects of the fourth embodiment will be described in the following, which are different to the second embodiment. The low pass filter unit LPF-U is not applied for the shown embodiment but may be applied in an alternative embodiment, if the relative frequency mismatch between the spectral characteristic SC1 of the amplification unit P-EMP-U and the inverted version of the spectral characteristic SC2 of the attenuation unit D-EMP-U is too large as described above regarding Figure 6.

The processing apparatus PA4 further contains a further directional coupler DC2 in the forward signal path between the attenuation unit D-EMP and the modulation unit MOD-U, an even further directional coupler DC3 in the feedback signal path between the attenuation unit ATT-U and the demodulation unit DEMOD-U, a determination unit DET-U, and a frequency adding unit FA-U.

The analogue forward signal fw_DE_OUT as the output signal of the attenuation unit D-EMP passes the directional coupler DC2, which extracts a small part (e.g. 30 dB) of the analogue forward signal fw_DE_OUT as a first analogue calibration signal Δfw_DE_OUT and provides the first analogue calibration signal Δfw_DE_OUT as a first input signal to the determination unit DET-U. A remaining part of the analogue forward signal fw_DE_OUT is applied as an input signal to the modulation unit MOD-U.

The analogue feedback signal fb_ATT_OUT as the output signal of the attenuation unit ATT-U passes the directional coupler DC3, which extracts a small part (e.g. 30 dB) of the analogue feedback signal fb_ATT_OUT as a second analogue calibration signal Δfb_ATT_OUT and provides the second analogue calibration signal Δfb_ATT_OUT as a second input signal to the determination unit DET-U. A remaining part of the analogue feedback signal fb_ATT_OUT is applied as an input signal to the demodulation unit DEMOD-U.

The determination unit DET-U may determine an offset frequency f_OFFSET between the first analogue calibration signal Δfw_DE_OUT and the second analogue calibration signal Δfb_ATT_OUT for example by an LR estimator (LR = likelihood ratio) according to following equation:

$$f_{offset} = \frac{1}{\pi T(N+1)} \cdot arg\left\{\sum_{l=1}^{N} R_{\Delta fw - \Delta fb}(l)\right\} \qquad (17)$$

with
*T*: sampling rate
*N*: a number of samples to be considered, which corresponds to a maximum time delay to be considered

$$R_{\Delta fw - \Delta fb}(\tau) = E\{\Delta fw\_DE\_OUT(t) - \Delta fb\_ATT\_OUT(t)\}$$

$$= \alpha \cdot R_{\Delta fw - \Delta fw}(\tau - D)$$

: cross-correlation function between the first analogue calibration signal Δfw_DE_OUT and the second analogue calibration signal Δfb_ATT_OUT,

$R_{\Delta fw-\Delta fw}(\tau - D)$: auto-correlation function of the first analogue calibration signal Δfw_DE_OUT.

The cross-correlation function $R_{\Delta fw-\Delta fb}(\tau)$ achieves a maximum for $\tau = D$, which can be determined by calculating expectations values of the cross-correlation function $R_{\Delta fw-\Delta fb}(\tau)$ for a predefined number of samples within a pre-selected time window.

The offset frequency f_OFFSET, which is calculated by the determination unit DET-U, is provided as a first input signal to the frequency adding unit FA-U. The frequency f_LO, which is generated by the local oscillator LO1, is provided as a second input signal to the frequency adding unit FA-U. The frequency adding unit FA-U may be for example a frequency mixer, which produces new frequency signals at sum frequency f_SUM by equation $f_{SUM} = f_{LO} + f_{OFFSET}$ and difference frequency f_DIFF by equation $f_{DIFF} = f_{LO} - F_{OFFSET}$ of the original frequencies f_OFFSET and f_LO. The sum frequency f_SUM is provided as a downconversion frequency to the demodulation unit DEMOD-U.

Operating the demodulation unit DEMOD-U with the sum frequency f_SUM instead of the frequency f_LO allows to compensate the frequency shift of the feedback signal fb, which is obtained in the analogue forward signal fw_DE_OUT and successive analogue forward signals fw_MOD_OUT, fw_PA_OUT by a possible frequency deviation between the spectral characteristic SP1 and an inverted version of the spectral characteristic SP2.

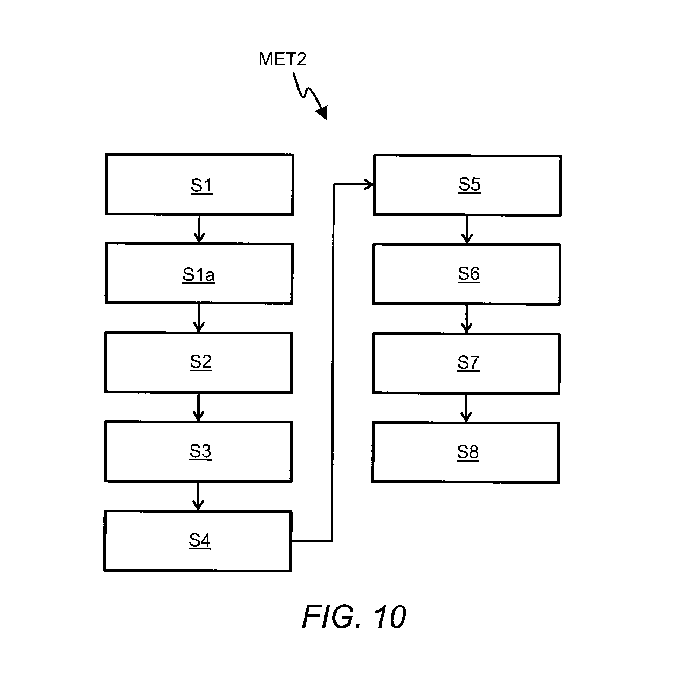

Referring to Figure 10 a flow diagram of a method MET2 containing the four steps S1 to S4 in accordance to the first embodiment and containing additional steps S1a and S5 to S8 in accordance to the second, third or fourth embodiment of the invention is shown. The number of the steps for performing the method MET2 is not critical, and as can be understood by those skilled in the art, that the number of the steps and the sequence of the steps, may vary without departing from the scope of the embodiments of the invention as defined in the appended claims. The various steps of the method MET2 are executed by corresponding processing units of the processing apparatus PA2, PA3, or PA4.

In a further step S1a between the step S1 and the step S2, the digital forward signal fw is pre-distorted based on the digital feedback signal fb_DPD_IN.

In a next step S5 after the step S4, the analogue feedback signal fw_DE_OUT is up-converted by the frequency f_LO for obtaining the analogue forward signal fw_MOD_OUT.

In a further step S6, the second signal fw_MOD_OUT is amplified by the power amplifier unit PA-U for obtaining the analogue forward signal fw_PA_OUT.

In a next step S7, the analogue feedback signal fb is extracted from the analogue forward signal fw_PA_OUT.

In a further step S8, the frequency offset f_OFFSET between the feedback signal fb and the forward signal fw is adapted and removed.

The step S8 may either contain a delay compensation of the digital forward signal fw and the digital feedback signal fb_DPD_IN (see Figure 7 and 8) or may contain a determination of the offset frequency f_OFFSET and a downconversion of the analogue feedback signal fb_ATT_OUT by the sum frequency f_SUM (see Figure 9).

Further embodiments provide a computer program having a program code for performing one of the above methods when the computer program is executed on a computer or processor.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as magnetic disks and magnetic tapes, hard drives, or optically readable digital data storage media. The embodiments are also intended to cover computers programmed to perform said steps of the above-described methods or (field) programmable logic arrays ((F)PLAs) or (field) programmable gate arrays ((F)PGAs), programmed to perform said steps of the above-described methods.

The description and drawings merely illustrate the principles of the embodiments of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing or to perform a certain function, respectively. Hence, a "means for s.th." may as well be understood as a "means being adapted or suited for s.th.". A means being adapted for performing a certain function does, hence, not imply that such means necessarily is performing said function (at a given time instant).

The functions of the various elements of the processing apparatus, which are shown in Figures 1 to 10, including any functional blocks labeled as "means", "means for generating", "means for amplifying", "means for attenuating", "means for providing" etc., may be provided through the use of dedicated hardware, such as "a generator", "an amplifier" , "an attenuator" , "a coupler", etc. as well as hardware capable of executing software in association with appropriate software. Moreover, any entity described herein as "means", may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, DSP hardware, network processor, ASIC (ASIC =application specific integrated circuit), FPGA, ROM (ROM =read only memory) for storing software, RAM (RAM = random access memory), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

**Claims**

1. A method (MET1, MET2) for signal conditioning in a processing apparatus (PA1, PA2, PA3, PA4), said method (MET1, MET2) comprising the steps of:

   - generating (S1) a first signal (fw) with a predefined spectral bandwidth (BW),
   - amplifying (S2) spectral components of said first signal (fw) with a frequency outside said predefined spectral bandwidth (BW) for obtaining an amplified first signal (fw_PE_OUT),
   - processing (S3) said amplified first signal (fw_PE_OUT) for obtaining a second signal (fw_DAC_OUT), and
   - attenuating (S4) spectral components of said second signal (fw_DAC_OUT) with a frequency outside said predefined spectral bandwidth (BW) for obtaining an attenuated second signal (fw_DE_OUT).

2. Method (MET1, MET2) according to claim 1, wherein said at least one processing unit (DAC-U) is a digital-to-analogue converter and wherein said processing step (S3) is a conversion of said amplified first signal (fw_PE_OUT) being a digital signal into said second signal (fw_DAC_OUT) being an analogue signal.

3. Method (MET1, MET2) according to any of the preceding claims, wherein said amplifying step (S2) is performed by a pre-emphasis circuit (P-EMP) and wherein said attenuating step (S4) is performed by a de-emphasis circuit (D-EMP).

4. Method (MET1, MET2) according to claim 3, wherein said pre-emphasis circuit (P-EMP) is an inverted low pass filter.

5. Method (MET1, MET2) according to claim 4, wherein said inverted low pass filter is an inverted Bessel filter, in particular with an order 5 for coefficients of a transfer function of the inverse Bessel filter.

6. Method (MET1, MET2) according to claim 3, wherein said de-emphasis circuit (D-EMP) is a low pass filter.

7. Method (MET1, MET2) according to claim 6, wherein said low pass filter is a Butterworth filter, in particular with an order 5 for coefficients of a transfer function of the Butterworth filter.

8. Method (MET1) according to any of the preceding claims 3 to 7, wherein a relative frequency difference for a same gain value or a same attenuation value of a spectral characteristic of said pre-emphasis circuit (P-EMP) and of a spectral characteristic of said de-emphasis circuit (D-EMP) is within a predefined range, in particular from 0 percent to 2 percent for said predefined spectral bandwidth (BW) being equal to or larger than 20 MHz or from 0 percent to 4 percent for said predefined spectral bandwidth (BW) being smaller than 20 MHz.

9.  Method (MET2) according to any of the preceding claims 3 to 7, wherein said method (MET2) further comprises the steps of:

    - pre-distorting (S1a) before said amplifying step (S2) said first signal (fw) based on a digital form (fb_DPD_IN) of a feedback signal (fb),
    - up-converting (S5) said attenuated second signal (fw_DE_OUT) with a predefined frequency (f_LO) for obtaining an up-converted second signal (fw_MOD_OUT),
    - amplifying (S6) said up-converted second signal (fw_MOD_OUT) for obtaining an amplified second signal (fw_PA_OUT),
    - extracting (S7) said feedback signal (fb) from said amplified second signal (fw_PA_OUT), and
    - adapting and removing (S8) a frequency offset (f_OFFSET) between said feedback signal (fb) and said first signal (fw).

10. Method (MET2) according to claim 9, wherein said removing and adapting step (S8) comprises a time delay compensation of said first signal (fw) and said digital form (fb_DPD_IN) of said feedback signal (fb).

11. Method (MET2) according to claim 9, wherein said removing and adapting step (S8) comprises a determination of said frequency offset (f_OFFSET) and a down-conversion of said feedback signal (fb) by a sum frequency (f_SUM) of said predefined frequency (f_LO) and said frequency offset (f_OFFSET).

12. A processing apparatus (PA1, PA2, PA3, PA4) for signal conditioning, said processing apparatus (PA1, PA2, PA3, PA4) comprising:

    - means (SG-U) for generating a first signal (fw) with a predefined spectral bandwidth (BW),
    - means (P-EMP) for amplifying spectral components of said first signal (fw) with a frequency outside said predefined spectral bandwidth (BW) for obtaining an amplified first signal (fw_PE_OUT),
    - at least one processing unit (DAC-U) for processing said first signal () and for obtaining a second signal (fw_DAC_OUT), and
    - means (D-EMP) for attenuating spectral components of said second signal (fw_DAC_OUT) with a frequency outside said predefined spectral bandwidth (BW) for obtaining an attenuated second signal (fw_DE_OUT).

13. Processing apparatus (PA1, PA2, PA3, PA4) according to claim 12, wherein said processing apparatus (PA1, PA2, PA3, PA4) is a transmitter, in particular a radio transmitter, and wherein said signal is a communication signal, in particular a radio communication signal.

14. Processing apparatus (PA1, PA2, PA3, PA4) according to claim 13, wherein said transmitter is a direct modulation transmitter or a heterodyne intermediate frequency transmitter.

**FIG. 1**

SC1

M [dB]

NF [xπ rad/sample]

*FIG. 2*

*FIG. 3*

D-EMP

*FIG. 4*

EP 2 765 704 A1

*FIG. 5*

FIG. 6

FIG. 7

DPD-U2

fw

fw_DC_OUT

fw_GC_OUT

fw_DPD_OUT

```
┌─────────┐      ┌─────────┐      ┌─────────┐
│  DC-U   │─────▶│  GC-U   │─────▶│ DPD-U1  │────▶
│         │─────▶│         │─────▶│         │
└─────────┘      └─────────┘      └─────────┘
```

fb_DPD_IN

fb_DC_OUT

fb_GC_OUT

EP 2 765 704 A1

*FIG. 8*

*FIG. 9*

FIG. 10

**Europäisches Patentamt**
**European Patent Office**
**Office européen des brevets**

# EUROPEAN SEARCH REPORT

Application Number

EP 13 30 5166

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 326 845 B1 (MIYAJI MASAYUKI [JP] ET AL) 4 December 2001 (2001-12-04) <br> * figures 3, 5 * | 1,3, 12-14 | INV. <br> H03F1/32 <br> H03G11/00 <br> H04L27/26 |
| A | US 5 666 659 A (KERNAHAN KENT [US] ET AL) 9 September 1997 (1997-09-09) <br> * abstract * | 1 | |
| A | US 2008/130767 A1 (LOZHKIN ALEXANDER N [JP]) 5 June 2008 (2008-06-05) <br> * figure 7 * | 1 | |
| A | US 2002/191705 A1 (MELSA PETER J [US] ET AL) 19 December 2002 (2002-12-19) <br> * figure 2 * | 1 | |
| A | US 5 294 985 A (DESOR HANS-JUERGEN [DE] ET AL) 15 March 1994 (1994-03-15) <br> * figure 1 * | 1 | |

| TECHNICAL FIELDS SEARCHED (IPC) |
|---|
| H03F <br> H03G <br> H04L |

The present search report has been drawn up for all claims

| Place of search | Date of completion of the search | Examiner |
|---|---|---|
| Munich | 9 July 2013 | Agerbaek, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 13 30 5166

This annex lists the patent family members relating to the patent documents cited in the above-mentioned European search report.
The members are as contained in the European Patent Office EDP file on
The European Patent Office is in no way liable for these particulars which are merely given for the purpose of information.

09-07-2013

| Patent document cited in search report | | | Publication date | Patent family member(s) | | | Publication date |
|---|---|---|---|---|---|---|---|
| US 6326845 | B1 | | 04-12-2001 | EP | 1030441 | A2 | 23-08-2000 |
| | | | | US | 6326845 | B1 | 04-12-2001 |
| US 5666659 | A | | 09-09-1997 | NONE | | | |
| US 2008130767 | A1 | | 05-06-2008 | EP | 1928141 | A2 | 04-06-2008 |
| | | | | JP | 4653724 | B2 | 16-03-2011 |
| | | | | JP | 2008141415 | A | 19-06-2008 |
| | | | | US | 2008130767 | A1 | 05-06-2008 |
| US 2002191705 | A1 | | 19-12-2002 | NONE | | | |
| US 5294985 | A | | 15-03-1994 | DE | 59109070 | D1 | 10-12-1998 |
| | | | | EP | 0529129 | A1 | 03-03-1993 |
| | | | | JP | 3281419 | B2 | 13-05-2002 |
| | | | | JP | H05211619 | A | 20-08-1993 |
| | | | | US | 5294985 | A | 15-03-1994 |

EPO FORM P0459

For more details about this annex : see Official Journal of the European Patent Office, No. 12/82